# EUROPEAN PATENT APPLICATION

(11) **EP 3 038 157 A1**
(43) Date of publication of application: **29.06.2016**
(21) Application number: 14199610.8
(22) Date of filing: 22.12.2014
(51) Int. Cl.: H01L 27/146, H01L 27/30

(54) **Detector structure for electromagnetic radiation sensing**

(71) Applicant: Nokia Technologies OY, 02610 Espoo (FI)
(72) Inventor: Voutilainen, Martti, 02660 Espoo (FI); Rouvala, Markku, 00620 Helsinki (FI)
(74) Representative: Nokia Corporation

(57) **Abstract**

An apparatus with at least two electromagnetic radiation sensor cells (141-144) that comprise graphene as an electromagnetic radiation absorbing material and electrical connections (150-155) between the at least two sensor cells. The electrical connections are at least partially made of graphene.

## Description

### TECHNICAL FIELD

The present application generally relates to detector structures configured for electromagnetic radiation sensing and in particular, but not exclusively, to x-ray detector structures.

### BACKGROUND

This section illustrates useful background information without admission of any technique described herein representative of the state of the art.

An image sensor is an apparatus that converts an optical image into an electric signal. It has been widely used in various imaging devices. Examples of image sensors include a CMOS (Complementary Metal-Oxide Semiconductor) sensor and a CCD (Charge Coupled Device) sensor. Depending on the characteristics of the image sensor, the sensor may be configured to operate on visible light wavelengths, on ultraviolet or infrared wavelengths or on x-ray wavelengths, for example.

### SUMMARY

Various aspects of examples of the invention are set out in the claims.

According to a first example aspect of the present invention there is provided an apparatus comprising a sensor structure that comprises
at least two electromagnetic radiation sensor cells, the sensor cells comprising graphene as an electromagnetic radiation absorbing material; and
electrical connections between the at least two sensor cells, wherein the electrical connections are at least partially made of graphene.

In an example embodiment, the electrical connections are fully made of graphene.

In an example embodiment, the apparatus comprises a plurality of said sensor cells and a plurality of said electrical connections made of graphene.

In an example embodiment, the sensor cells form a row of sensor cells or an array of sensor cells.

In an example embodiment, the electrical connections between the sensor cells comprise graphene layers that extend into the sensor cells.

In an example embodiment, the sensor cells form a row of sensor cells and the electrical connections between the sensor cells comprise graphene layers that extend through sensor cells of the row of sensor cells

In an example embodiment, the sensor cells form a row of sensor cells and the electrical connections between the sensor cells comprise graphene layers that extend over sensor cells of the row of sensor cells.

In an example embodiment, the sensor structure comprises graphene layers that extend through plurality of sensor cells of the structure.

In an example embodiment, the graphene layers that extend through plurality of sensor cells of the structure form said electrical connections between the sensor cells.

In an example embodiment, the sensor cells comprise a plurality of stacked electromagnetic radiation sensing units, wherein each sensing unit comprises an electromagnetic radiation sensing layer made of graphene.

In an example embodiment, the sensor cells comprise 20-40 of said stacked electromagnetic radiation sensing units, and wherein the electromagnetic radiation sensing layer in each sensing unit comprises 10-30 layers of graphene.

In an example embodiment, the sensor cells are x-ray sensor cells.

In an example embodiment, the apparatus is an x-ray detector.

According to a second example aspect of the present invention, there is provided a method comprising
detecting electromagnetic radiation in sensor cells of a sensor structure comprising at least two sensor cells, the sensor cells comprising graphene as an electromagnetic radiation absorbing material; and
delivering electrical signals to and from the sensor cells through electrical connections that are at least partially made of graphene.

Different non-binding example aspects and embodiments of the present invention have been illustrated in the foregoing. The embodiments in the foregoing are used merely to explain selected aspects or steps that may be utilized in implementations of the present invention. Some embodiments may be presented only with reference to certain example aspects of the invention. It should be appreciated that corresponding embodiments may apply to other example aspects as well.

### BRIEF DESCRIPTION OF THE DRAWINGS

For a more complete understanding of example embodiments of the present invention, reference is now made to the following descriptions taken in connection with the accompanying drawings in which:
Fig. 1 shows a top view of a sensor structure according to an example embodiment of the invention;
Fig. 2A shows a sectional view of a sensor structure according to an example embodiment of the invention;
Fig. 2B shows a sectional view of a sensor structure according to another example embodiment of the invention;
Fig. 3 shows a top view of an example sensor cell;
Fig. 4A shows a sectional view of an example sensor cell;
Fig. 4B shows a sectional view of another example sensor cell;
Fig. 5A shows a top view of an example sensor cell;
Fig. 5B shows a top view of an example sensor cell with row and column electrodes;
Fig. 5C shows a circuit diagram of an example sensor cell;
Figs. 6A-6D show sectional views of an example sensor structure with two sensor cells;
Fig. 7 shows a flow diagram illustrating a method according to an example embodiment of the invention; and
Fig. 8 shows a flow diagram illustrating a manufacturing method according to an example embodiment of the invention.

### DETAILED DESCRIPTION OF THE DRAWINGS

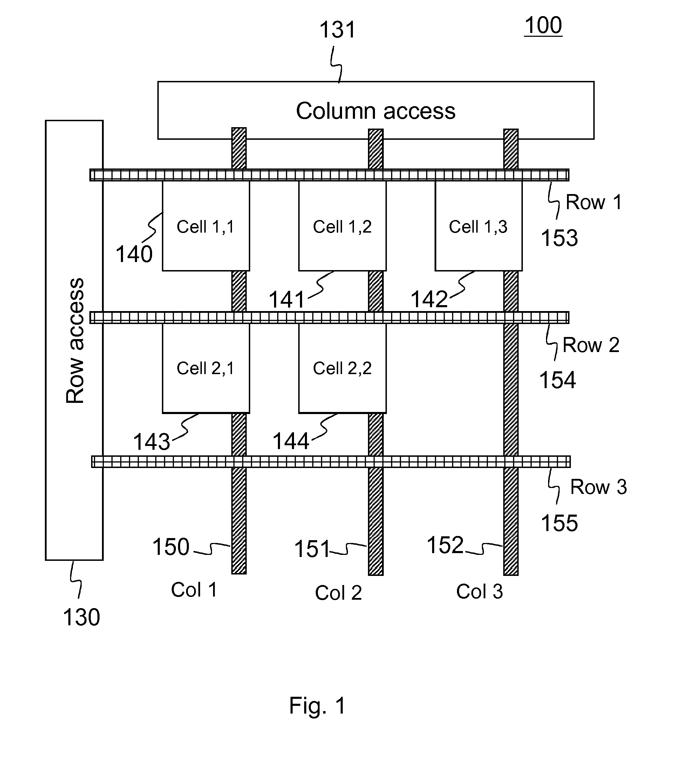

An example embodiment of the present invention and its potential advantages are understood by referring to Figs. 1 through 8 of the drawings. In this document, like reference signs denote like parts or steps.

An image sensor typically comprises a grid of pixels. The area of each pixel is typically from 1 µm x 1 µm (one square micrometer) to 100 µm x 100 µm. A sensor cell covers the area of one pixel and the sensor cells are combined into an array of cells to form the sensor. Also a single row of sensor cells may be used.

In x-ray imaging there is a need for bendable or stretchable detector structure as subjects to be x-rayed may have various different forms in various application areas. In addition to x-ray imaging, bendable or stretchable structures may suit electromagnetic radiation detectors in general. In an example embodiment electrical connections (interconnections) to and from sensor cells of an electromagnetic radiation detector structure, such as an x-ray detector structure, are made of graphene. In this way, a flexible or bendable or stretchable detector structure is achieved, as graphene is strong and flexible material. If the detector structure needs to be bendable to small radius, small pixel size may be used.

Embodiments of the invention may be applied for example in medical or security x-ray cameras.

In an example embodiment also the sensor cells of the electromagnetic radiation detector structure are made of graphene, and more specifically the sensor cells comprise a multilayer graphene structure. In an embodiment the sensor cells are x-ray sensor cells made of graphene. In an embodiment, multilayer graphene separated by thin dielectric is used as x-ray absorbing material. In an embodiment, an x-ray sensor cell comprises several graphene field effect transistor (GFET) layers separated by thin dielectric.

In an example embodiment a sensor cell comprises a plurality of graphene layers or a plurality of graphene layer stacks. In the following, x-ray sensors are discussed, but the disclosed structure may be used for detection of other electromagnetic radiation, too. For example, when detected x-rays have energies below 1 keV, 200 nm thick graphene layer absorbs large enough portion of incoming radiation. Pixel drain and source electrodes of each graphene layer of the sensor cell are at certain distance, so that when hot electrons and holes are generated into some of the graphene layers or graphene layer stacks, x-ray photon is absorbed and created electrons and holes or electrons knocked from grapheme atom reach the source and drain electrodes without significant recombination. When absorbed x-ray emits an electron and leaves carbon atom ionized, the electron is absorbed quickly in nearby graphene layers. The absorption methods at the target x-ray energies are photoelectric absorption, inelastic scattering, and elastic scattering, giving energy into sensor structure. Small voltage difference biasing is applied between source and drain electrode, created either by external supply voltage, by selecting electrodes from proper materials with different work functions or by chemical doping of the area near electrodes.

In an embodiment, an ambient light absorption filter, so called x-ray window, is made by covering the surface of the sensor cell by flexible foil composed of similar layered structure as the active sensor to make the x-ray window bendable and flexible, but without electrodes and electronics. In an alternative embodiment, more graphene layers are included in the sensor structure, and depending on the ambient light conditions, the graphene layer(s) near the outer surface of the sensor cell are not used for signal detection but only as x-ray window.

In an example embodiment system-wide graphene layers are used so that graphene layers forming interconnections between the sensor cells extends into the sensor cells. The graphene layers forming the interconnections and extending into the sensor cells may form part of the sensor cells. For example, row access electrodes and/or column access electrodes and/or other electrical connections made of graphene extend through all pixels or sensor cells in a row or a column of a sensor structure. Alternatively or additionally, the electrical connections may extend over or below the pixels or sensor cells.

In an example embodiment a sensor structure comprises graphene layers that extend from sensor cells of the structure to electrical connections between the sensor cells. Graphene layers may extend through plurality of sensor cells of a sensor structure. Such graphene layers may form electrical connections between the sensor cells.

In an embodiment connections to source and drain electrodes of sensor cells are implemented as an edge contact, a top contact, a bottom contact or by using any combination of these. These connections may be used for forming connections to the source and drain electrodes of the sensor cells from the graphene interconnections. For example, graphene edge connection may be used to create metal to graphene connection between sensor cell electrodes and graphene row and column access interconnection bars.

In an example embodiment, source and drain electrodes of the sensor cells are made of the same graphene layers as the actual sensor. In this case, for example chemical doping may be used for making the electrode functions into the graphene sensing layers.

Fig. 1 shows a top view of a sensor structure 100 according to an example embodiment of the invention. The structure 100 comprises sensor cells 140-144, row access functionality 130 and column access functionality 131, and electrical connections or interconnections 153-156 that may be used to deliver electrical signals to and from the sensor cells 140-144.

The sensor cells 140-144 are configured to sense photons in certain wavelength area. In an example the sensor cells 140-144 are configured to sense x-ray signals. In another example the sensor cells 140-144 are configured to sense electromagnetic radiation. The sensor cells are arranged in an array, the cells 140-142 forming row 1, cells 140 and 143 forming column 1, cells 141 and 144 forming column 2 and so on.

The electrical connections 150-155 are made of graphene. The electrical connections 150-152 provide column access and may be used to read detected signals from the sensor cells 140-144. In an example embodiment the column access connections reside below or under or on the back side of the sensor cells 140-144. The electrical connections 153-155 provide row access and may be used to deliver for example reset, row and power supply (VDD) signals to the sensor cells. In an example embodiment the row access connections reside on top of or in from of the sensor cells 140-144.

It must be noted that Fig. 1 shows only five sensor cells 140-144 and associated interconnections. Clearly this is only an illustrative example and in practice it is likely that there are more cells and interconnections. At minimum there are two sensor cells. It is to be noted that it is not mandatory that the sensor cells form an array with rows and columns. Instead also other forms are possible. For example in an embodiment there is a single row or a single column of sensor cells.

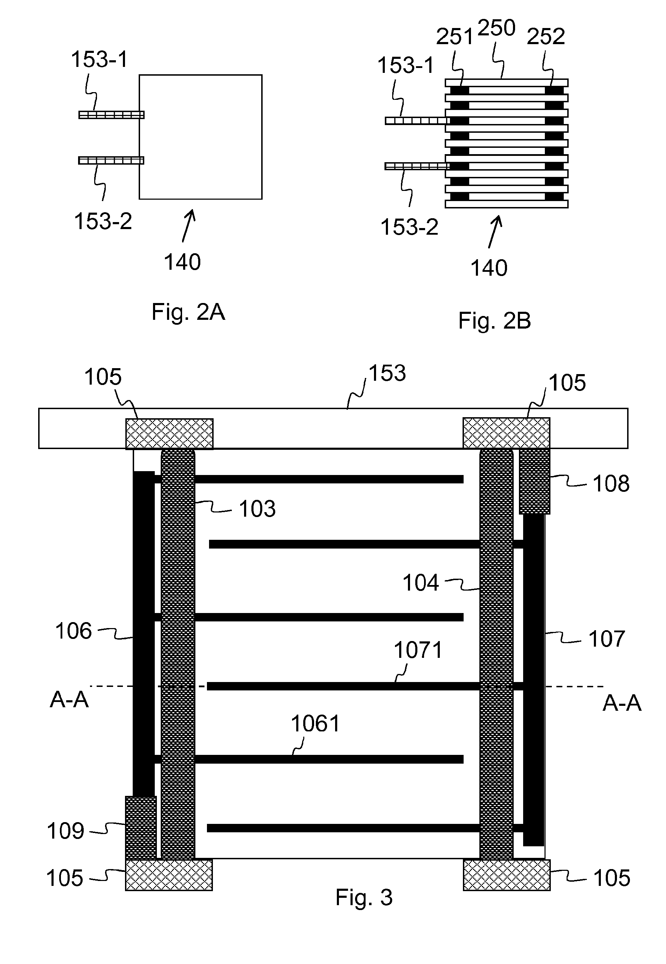

Fig. 2A shows a sectional view of a sensor structure according to an example embodiment of the invention. The sectional view illustrates an example implementation showing an interconnection 153 and a sensor cell 140. In this example, the interconnection 153 is formed of two layers of graphene 153-1 and 153-2.

Fig. 2B shows a sectional view of a sensor structure according to another example embodiment of the invention. The sectional view illustrates an example implementation showing an interconnection 153 and a sensor cell 140. In this example implementation the sensor cell 140 is formed of a plurality of graphene layers 250 and electrodes 251, 252 between the graphene layers 250. The electrodes may be made of evaporated metal, printed metals or printed Graphene Oxide inks. Also in this example, the interconnection is formed of two layers of graphene 153-1 and 153-2. The graphene layers 153-1 and 153-2 of the interconnection may be attached for example to the electrodes 251 of the sensor cell 140. In practice, the attachment of the graphene layers 153-1 and 153-2 to the sensor cell 140 may be through control electronics (an example of control electronics 105 is shown in Fig 3).

It is noted that Figs 2A and 2B are schematic illustrations that may not reflect exact implementation details. In various embodiments the interconnection 153 may connect to the sensor cell 140 on the top of the sensor cell, through the sensor cell or below the sensor cell. In an example implementation, a row access connection is made on top of or from the front side of the sensor cell 140 and a column access connection is made below or from the back side of the sensor cell 140. The exact placement of the connections may affect overall flexibility or bendability of the sensor structure.

It must be noted that Figs. 2A and 2B show two layer graphene interconnection as an illustrative example only. In practice there may be more layers or only one layer.

In the following example x-ray sensor cells formed of a plurality of graphene layers are discussed. The disclosed structure may however be used for detection of other electromagnetic radiation, too.

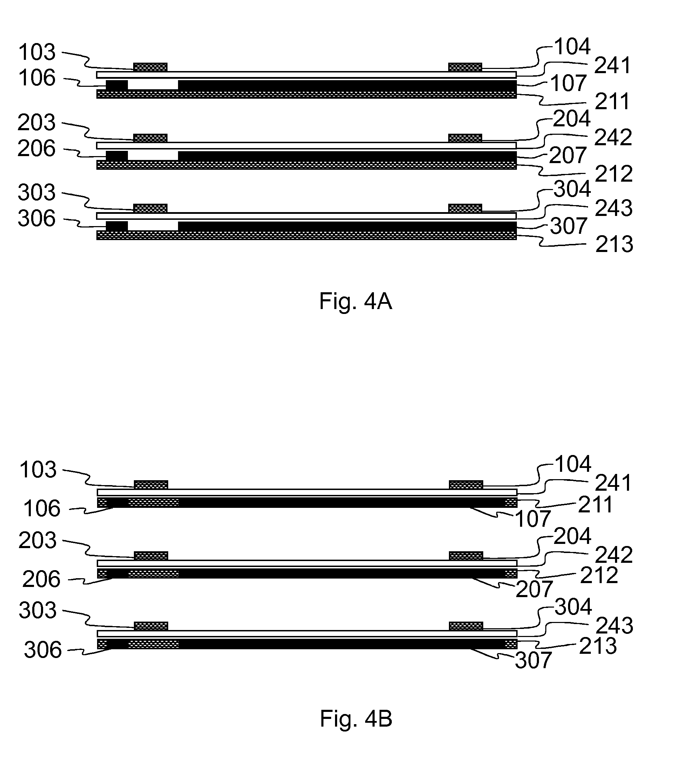

Fig. 3 shows a top view of an example sensor cell. The sensor cell covers the area of one pixel in an example embodiment. In the shown example a sequence of a detecting structure and an amplifier layer is repeated in a vertical direction in the sensor so that large enough portion of incoming x-ray radiation (or other electromagnetic radiation) may ultimately be detected (or obtained). This is described in more detail in connection with Fig. 4A and 4B. In Fig. 3 there is shown a first or an uppermost detecting structure with a pre-amplifier. The source and drain electrodes 106 and 107 of the detecting structure reside above photon sensing layers of graphene (more clearly shown in Fig. 4). The source and drain electrodes 106 and 107 have a finger geometry. The fingers of the electrodes form an interdigitated pattern. The reference numeral 1061 shows one of the fingers of the source electrode 106, and the reference numeral 1071 shows one of the fingers of the drain electrode 107. The source and drain electrodes 106 and 107 may be made of metal. They collect the holes and electrons generated by photons in the photon sensing layers.

The source and drain electrodes 106 and 107 of the detecting structure serve as gates for a graphene-based field effect transistor (FET) in an amplifier layer above the detecting structure. The graphene FET therefore functions as a pre-amplifier for the detecting structure amplifying the photocurrent generated by the detecting structure. The graphene FET amplifier channel 104 may be implemented by a graphene nanoribbon, the graphene FET (GFET) thereby forming a graphene nanoribbon field effect transistor (GNR-FET). The graphene nanoribbon may consist of a monolayer or bilayer of graphene.

In an example embodiment, the amplifier layer additionally comprises a reset transistor 108. In an example embodiment, the reset transistor 108 is also made of graphene. The logical operation of the reset transistor may correspond to conventional reset transistors. It functions as a switch configured to remove generated charge when needed. The generated charge herein refers, for example, to the charge generated by leakage currents and/or by an earlier photocurrent from the detector's source and drain electrodes 106 and 107. The reset transistor 108 and the graphene FET channel 104 are connected to control electronics 105. The control electronics 105 may reside at the side(s) of the pixel.

A second amplifier channel 103 and a second reset transistor 109 function similarly as the channel 104 and reset transistor 108, and are similarly connected to control electronics 105. Then an amplified signal can be obtained as a differential signal, that is, as a sum of signals of amplifier channels 103 and 104.

In an alternative embodiment, one of the electrodes 106 and 107 (either the source electrode 106 or the drain electrode 107) is connected to signal ground. In this example embodiment, the other of the amplifier channels 103 and 104 is not needed.

Fig 3 shows a row access electrode 153 on one side of the pixel. The row access electrode connects to the pixel through the control electronics 105 and may be used to selectively connect amplified signal from the pixel to a column access electrode placed e.g. below the pixel (column access electrode not shown in the Figure).

Fig. 4A shows a sectional view of the sensor cell of Fig. 3 in accordance with an example embodiment of the invention. A cross-section has been made along the line A-A shown in Fig. 3. On the top the detector comprises a first detecting layer implementing the first detecting structure, and a first amplifier layer implementing a first pre-amplifier above the first detecting layer. In more detail, the first detecting layer comprises first photon sensing layer(s) 211 made of graphene. There may be more than one layer or several layers of graphene on top of each other. In an example embodiment, there may be up to twenty, 20, graphene layers in a stack. As an example, there may be e.g. 5, 10, 20 or 30 graphene layers. Above the first photon sensing layer(s) 211 the structure comprises the source and drain electrodes 106 and 107 of the first detecting structure. A dielectric layer 241 above the source and drain electrodes 106 and 107 and below the graphene FET channels 103 and 104 of the first amplifier layer separates the first detecting structure from the first amplifier layer. The source and drain electrodes 106 and 107 of the first detecting structure serve as top gates for the graphene FET in the first amplifier layer above the first detecting structure. The graphene FET therefore functions as a pre-amplifier for the first detecting structure amplifying the photocurrent generated by the first detecting structure.

Below the first detecting structure the detector comprises a second detecting layer implementing a second detecting structure, and a second amplifier layer implementing a second pre-amplifier above the second detecting layer. The second detecting layer and detecting structure, and the second amplifier layer and pre-amplifier basically correspond in both structure and operation to the first detecting layer and detecting structure, and the first amplifier layer and pre-amplifier, respectively. In more detail, the second detecting layer comprises second photon sensing layer(s) 212 made of graphene. There may be more than one layer or several layers of graphene on top of each other, e.g. 5, 10, 20 or 30 layers. Above the second photon sensing layer(s) 212 the structure comprises source and drain electrodes 206 and 207 of the second detecting structure. A dielectric layer 242 above the source and drain electrodes 206 and 207 and below graphene FET channels 203 and 204 of the second amplifier layer separates the second detecting structure from the second amplifier layer. The source and drain electrodes 206 and 207 of the second detecting structure serve as top gates for the graphene FET in the second amplifier layer above the second detecting structure. The graphene FET therefore functions as a pre-amplifier for the second detecting structure amplifying the photocurrent generated by the second detecting structure.

Below the second detecting structure the detector comprises a third detecting layer implementing a third detecting structure, and a third amplifier layer implementing a third pre-amplifier above the third detecting layer. The third detecting layer and detecting structure, and the third amplifier layer and pre-amplifier basically correspond in both structure and operation to the first and second detecting layers and detecting structures, and the first and second amplifier layers and pre-amplifiers, respectively. In more detail, the third detecting layer comprises third photon sensing layer(s) 213 made of graphene. There may be more than one layer or several layers of graphene on top of each other, e.g. 5, 10, 20 or 30 layers. Above the third photon sensing layer(s) 213 the structure comprises source and drain electrodes 306 and 307 of the third detecting structure. A dielectric layer 243 above the source and drain electrodes 306 and 307 and below graphene FET channels 303 and 304 of the third amplifier layer separates the third detecting structure from the third amplifier layer. The source and drain electrodes 306 and 307 of the third detecting structure serve as top gates for the graphene FET in the third amplifier layer above the third detecting structure. The graphene FET therefore functions as a pre-amplifier for the third detecting structure amplifying the photocurrent generated by the third detecting structure.

Fig. 4B shows a sectional view of a sensor cell in accordance with another example embodiment of the invention. In this embodiment the electrodes of the sensor cell are prepared by chemical doping of the sensor layer. By using this structure one may eliminate possible contact problems between the sensor and electrode.

The sensor cell of Fig. 4B comprises three detecting structures stacked on top of each other in a similar manner as shown in Fig. 4A. The uppermost or first detecting structure comprises graphene FET channels 103 and 104 of an amplifier layer on top of a dielectric layer 241. Below the dielectric layer 241 there are a photon sensing layer 211 made of graphene and source and drain electrodes 106 and 107 formed in the sensing layer 211.

A second detecting structure below the first detecting structure comprises graphene FET channels 203 and 204 of an amplifier layer on top of a dielectric layer 242. Below the dielectric layer 242 there are a photon sensing layer 212 made of graphene and source and drain electrodes 206 and 207 formed in the sensing layer 212.

A third detecting structure below the second detecting structure comprises graphene FET channels 303 and 304 of an amplifier layer on top of a dielectric layer 243. Below the dielectric layer 243 there are a photon sensing layer 213 made of graphene and source and drain electrodes 306 and 307 formed in the sensing layer 213.

The sensing layers 211, 212 and 213 may comprise plurality of layers of graphene. There may be e.g. 5, 10, 20 or 30 layers of graphene.

In addition to the layers shown in Fig 4A and 4B, sensor cells of an embodiment may comprise a filter layer between the detecting structures (e.g. between the sensing layer 211 and the graphene FET channels 203 and 204 of the below amplifier layer). The filter layer may be for example an x-ray filter. It is to be noted that the filters are not mandatory.

In an embodiment x-ray sensor cells made of multilayer graphene are used so that total energy of several x-ray photons is summed together to make a signal similar to photography applications.

Figs. 4A and 4B show three detecting structures or detecting units stacked on top of each other, but it is to be understood that this is an illustrative example only and that the number of detecting units is not limited to this example. In an example embodiment there are 20-40 detecting units. Alternatively, there may be 2-20 or 40-60 detecting units. If each detecting unit comprises 20 layers of graphene and there are 20-40 detecting units there may be altogether 200-400 graphene layers to absorb electromagnetic radiation, e.g. x-rays.

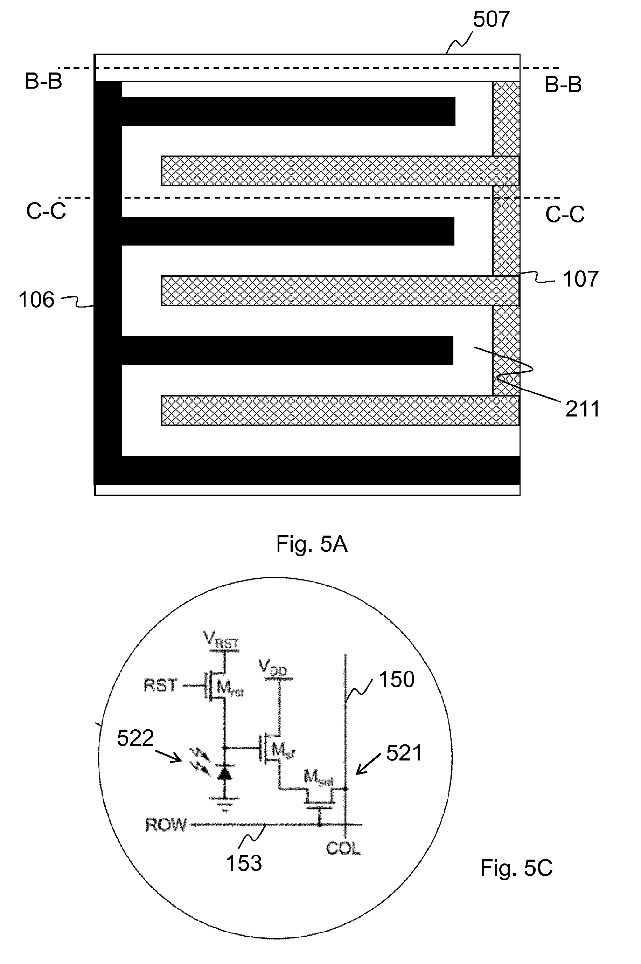

Fig. 5A shows a top view of an example sensor cell. The sensor cell comprises a pre-amplifier 507 on one edge of the cell (top or upper edge in the shown example), source electrode 106 and drain electrode 107, and graphene sensing layer 211. The source and drain electrodes 106 and 107 have a finger geometry. The fingers of the electrodes form an interdigitated pattern.

It is noted Fig 5A shows one possible layout, but other alternatives are possible, too. For example, the pre-amplifier 507 could be placed on right or left side of the cell, like shown for example in Fig 3. Also the source and drain electrodes may have different geometry.

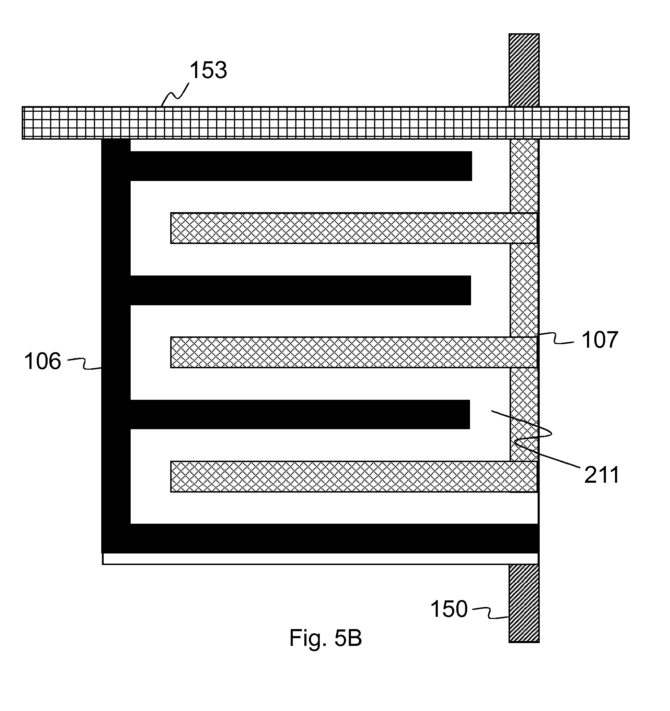

Fig. 5B shows a top view of an example sensor cell with row and column electrodes 153 and 150. The sensor cell of Fig 5B is similar to the sensor cell of Fig 5A. Fig 5B shows row access column 153 on top of or on the front side of the sensor cell and column access electrode 153 below or on the back side of the sensor cell. In a sensor structure the row access electrode 153 may extend through all pixels in one row and the column access electrode 150 may extend through all pixels in one column.

Fig. 5C shows a circuit diagram of an example sensor cell. The diagram comprises a reset transistor Mrst, read-out transistor Msf, and select transistor Msel, and a diode 522 that represents the sensor with source and drain electrodes, as well as row and column electrodes 153 and 150.

Row access electrodes, e.g. the row access electrode 153 of Fig 5B on top of sensor layers, are connected to select transistor Msel gates. Source and drain electrodes of the sensor, e.g. the source and drain electrodes 106 and 107 of Fig 5A and 5B, are connected to the pre-amplifier, which connects amplified signal to the column electrode 150 under the control of the row access electrode 153.

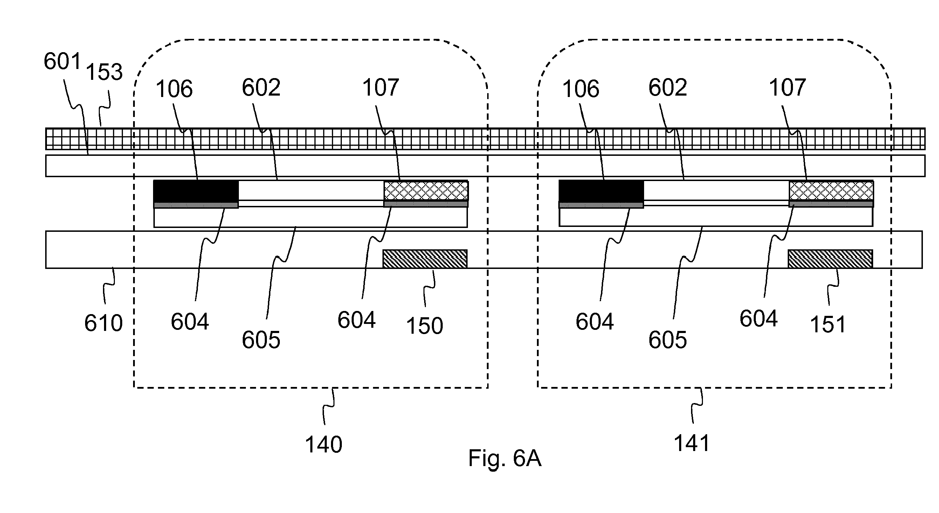

Figs. 6A-6D show sectional views of an example sensor structure with two sensor cells 140 and 141, e.g. corresponding cells of Fig. 1. Two sensor cells are shown for illustrative purposes, but clearly there may be any suitable number of cells. The sensor cells may be for example the sensor cells of Fig 5A. The structure of the sensor cells 140 and 141 is identical.

Fig 6A shows a sectional view at a pre-amplifier area of the sensor structure comprising e.g. sensor cells of Fig. 5A. One may consider that a cross-section has been made along the line B-B shown in Fig. 5A. On top the shown structure comprises a row access electrode 153. The row access electrode 153 may extend through all sensor cells in one row. Below the row access electrode, there is an isolating dielectric layer 601. The isolating dielectric layer 601 may extend through all sensor cells in one row or through all sensor cells in a sensor array or other sensor structure. Below the isolating dielectric layer 601, there are amplifier layers 602 and 605. The amplifier layers do not necessarily extend outside the sensor cells 140 and 141. The amplifier layer 602 comprises a source electrode 106 and a drain electrode 107. Below the amplifier layers 602 and 605 there is an isolating layer 610 and column access electrode 150 formed into the isolating dielectric layer. The isolating dielectric layer 610 may extend through all sensor cells in one row or through all sensor cells in a sensor array or other sensor structure. The column access electrode 150 may extend through all sensor cells in one column.

Grey areas 604 below the source electrodes 106 and the drain electrodes 107 illustrate top/bottom contact areas that may used to create a contact between the amplifier area and the source and drain electrodes 106 and 107.

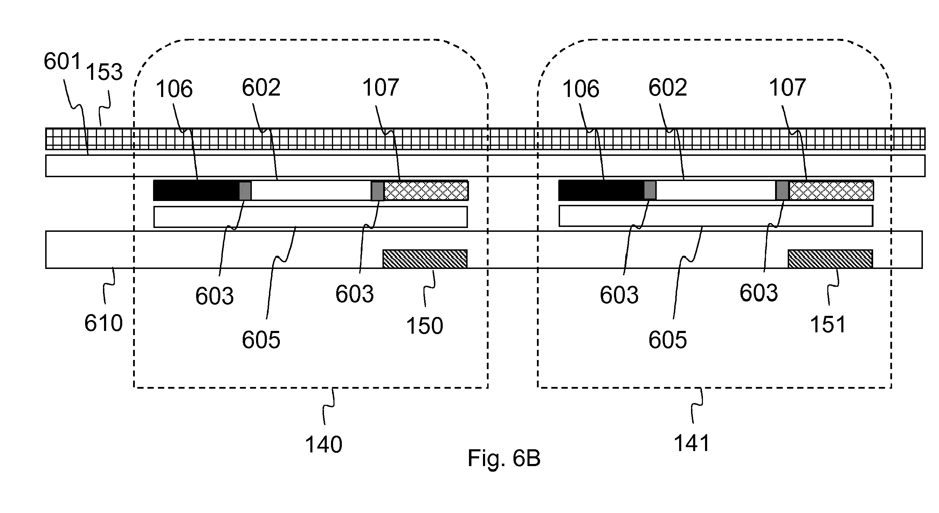

Fig 6B shows a sectional view at a pre-amplifier area of the sensor structure comprising e.g. sensor cells of Fig. 5A. One may consider that a cross-section has been made along the line B-B shown in Fig. 5A. On top the shown structure comprises a row access electrode 153. The row access electrode 153 may extend through all sensor cells in one row. Below the row access electrode, there is an isolating dielectric layer 601. The isolating dielectric layer 601 may extend through all sensor cells in one row or through all sensor cells in a sensor array or other sensor structure. Below the isolating dielectric layer 601, there are amplifier layers 602 and 605. The amplifier layers do not necessarily extend outside the sensor cells 140 and 141. The amplifier layer 602 comprises a source electrode 106 and a drain electrode 107. Below the amplifier layers 602 and 605 there is an isolating layer 610 and column access electrode 150 formed into the isolating dielectric layer. The isolating dielectric layer 610 may extend through all sensor cells in one row or through all sensor cells in a sensor array or other sensor structure. The column access electrode 150 may extend through all sensor cells in one column.

Grey areas 603 beside the source electrodes 106 and the drain electrodes 107 illustrate edge contact areas that may used to create a contact between the amplifier area and the source and drain electrodes 106 and 107. In this example, the source and drain electrodes of the sensor do not necessarily extend to the amplifier area. Since an edge contact is being used between the amplifier area and the source and drain electrodes 106 and 107, it is not necessary to extend the electrodes to the amplifier area to provide the contact.

It must be noted that Figs. 6A and 6B show the example contact areas 603 and 604 for illustrative purposes. In alternative embodiments, both of these may be used and/or other contact areas may be used, too.

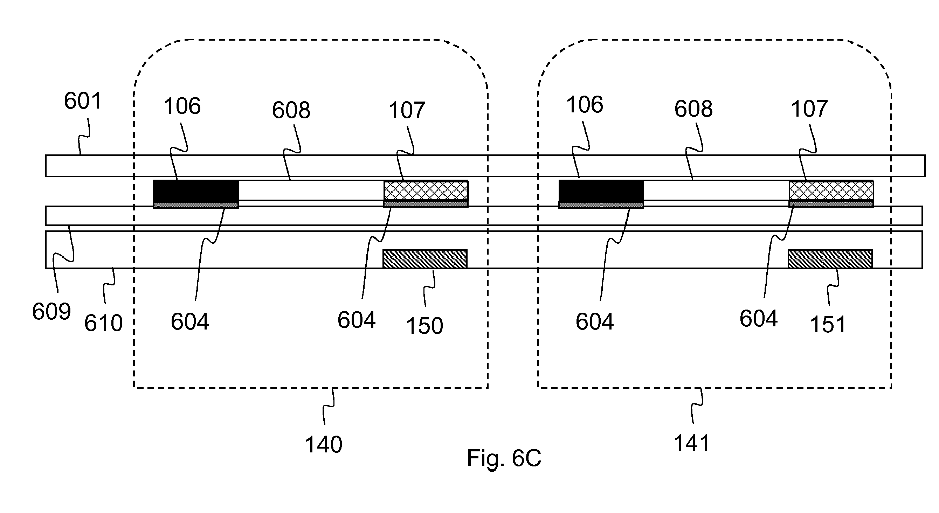

Fig 6C shows a sectional view at sensor area of the sensor structure comprising e.g. sensor cells of Fig. 5A. One may consider that a cross-section has been made along the line C-C shown in Fig. 5A. On top the shown structure comprises an isolating dielectric layer 601, which may be the same isolating dielectric layer that is shown in Figs. 6A and 6B. The isolating dielectric layer 601 may extend through all sensor cells in one row or through all sensor cells in a sensor array or other sensor structure. Below the isolating dielectric layer 601, there is dielectric layer 608 that comprises a source electrode 106 and a drain electrode 107 formed therein. The dielectric layer 608 does not necessarily extend outside the sensor cells 140 and 141. Below the dielectric layer 608, there is a sensing layer 609. The sensing layer 609 may extend through all sensor cells in one row or through all sensor cells in a sensor array or other sensor structure. Below the sensor layer 609 there is an isolating layer 610 and column access electrode 150 formed into the isolating dielectric layer. The isolating dielectric layer 610 may extend through all sensor cells in one row or through all sensor cells in a sensor array or other sensor structure. The column access electrode 150 may extend through all sensor cells in one column.

Grey areas 604 below the source electrodes 106 and the drain electrodes 107 illustrate top/bottom contact areas that may used to create a contact between the source and drain electrodes 106 and 107 and the sensing layer 609.

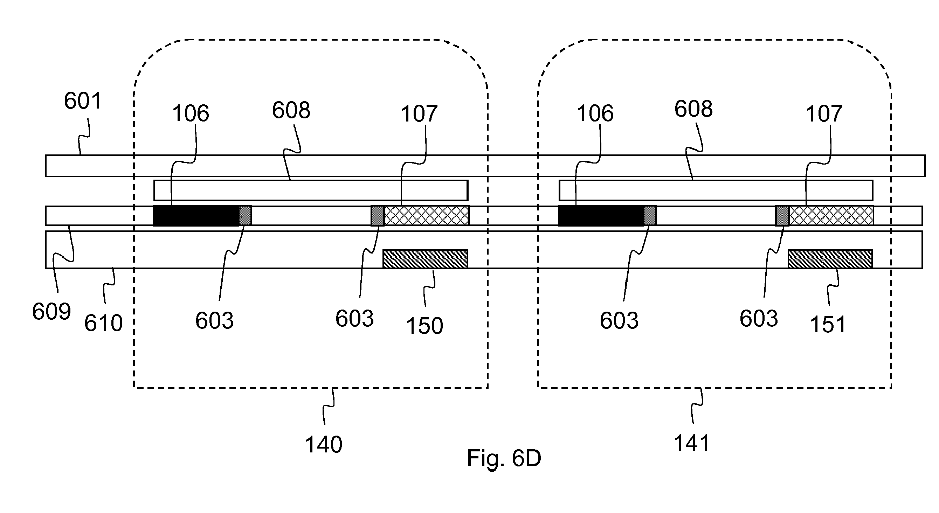

Fig 6D shows a sectional view at sensor area of the sensor structure comprising e.g. sensor cells of Fig. 5A. One may consider that a cross-section has been made along the line C-C shown in Fig. 5A. On top the shown structure comprises an isolating dielectric layer 601, which may be the same isolating dielectric layer that is shown in Figs. 6A and 6B. The isolating dielectric layer 601 may extend through all sensor cells in one row or through all sensor cells in a sensor array or other sensor structure. Below the isolating dielectric layer 601, there is dielectric layer 608. The dielectric layer 608 does not necessarily extend outside the sensor cells 140 and 141. Below the dielectric layer 608, there is a sensing layer 609 that comprises a source electrode 106 and a drain electrode 107 formed therein. The sensing layer 609 may extend through all sensor cells in one row or through all sensor cells in a sensor array or other sensor structure. Below the sensor layer 609 there is an isolating layer 610 and column access electrode 150 formed into the isolating dielectric layer. The isolating dielectric layer 610 may extend through all sensor cells in one row or through all sensor cells in a sensor array or other sensor structure. The column access electrode 150 may extend through all sensor cells in one column.

Grey areas 603 beside the source electrodes 106 and the drain electrodes 107 illustrate edge contact areas that may used to create a contact between the source and drain electrodes 106 and 107 and the sensing layer 609. In an embodiment the source and drain electrodes 106 and 107 are formed of the same graphene layer as the sensing layer 609 by chemical doping.

It is useful to realize that the term apparatus is used in this document with varying scope. In some of the broader claims and examples, the apparatus may refer to only a subset of the features presented in Fig. 1.

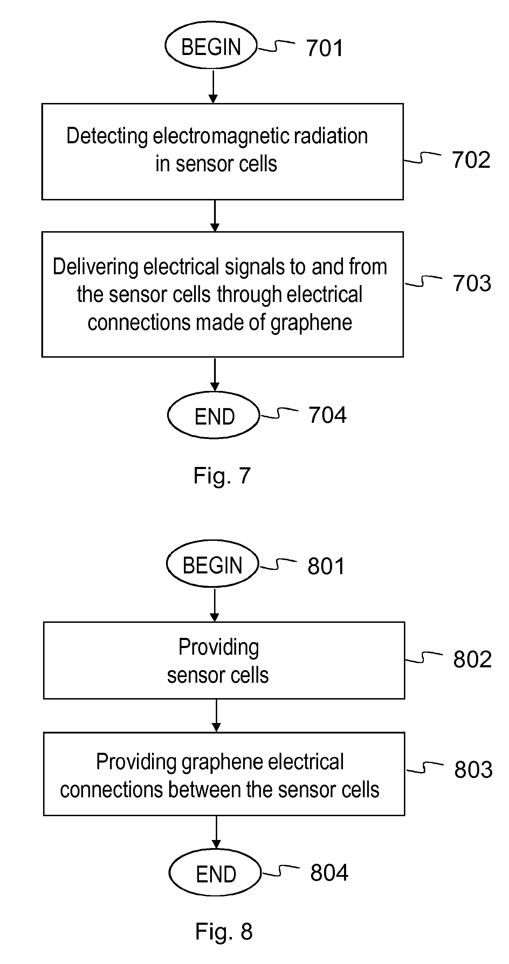

Fig. 7 shows a flow diagram illustrating a method according to an example embodiment of the invention. The method is performed for example in the sensor structure 100 of Fig 1. The method begins at step 701. In step 702, electromagnetic radiation is / photons are detected in sensor cells of a detector structure made of graphene. In step 703, electrical signals are delivered to and from the sensor cells through electrical connections or interconnections made of graphene. The electrical signals may comprise for example reset, row and power supply (VDD) signals delivered to the sensor cells and detected signals read from the sensor cells. The method ends at step 704.

Fig. 8 shows a flow diagram illustrating a manufacturing method according to an example embodiment of the invention. The method is performed for example to produce a sensor structure 100 of Fig 1. The method begins at step 801. In step 802, sensor cells made of graphene are provided for the sensor structure. In step 803, electrical connections or interconnections made of graphene are provided between the sensor cells. In an embodiment the interconnections are respectively manufactured to extend through all pixels in a row or a column of the sensor structure. The method ends at step 804.

Without in any way limiting the scope, interpretation, or application of the claims appearing below, a technical effect of one or more of the example embodiments disclosed herein is new x-ray detector structure (or a new electromagnetic radiation detector structure in more general terms). Another technical effect of one or more of the example embodiments disclosed herein is flexible or bendable or stretchable sensor structure. Graphene is very strong and flexible material and by using graphene interconnections it is possible to obtain flexible and strong detector structure. By using sensor cells made of multilayer graphene, it may be possible to further improve the characteristics, e.g. flexibility, of the detector structure. Various embodiment of the invention allow use of system wide graphene layers. This may further improve flexibility or bendability of the structure. Another technical effect of one or more of the example embodiments disclosed herein is that flexible or bendable sensor structure can be obtained without the user of stiffeners that are commonly needed in flexible or bendable or stretchable assemblies to avoid cracking or disconnections of interconnections between flexible/bendable/stretchable system structures and less rigid part or components. Another technical effect of one or more of the example embodiments disclosed herein is that no scintillator is needed because graphene channel of GFET is functioning as x-ray absorber and pre-amplifier.

If desired, the different functions discussed herein may be performed in a different order and/or concurrently with each other. Furthermore, if desired, one or more of the before-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It is also noted herein that while the foregoing describes example embodiments of the invention, these descriptions should not be viewed in a limiting sense. Rather, there are several variations and modifications which may be made without departing from the scope of the present invention as defined in the appended claims.

## Claims

1. An apparatus, comprising a sensor structure that comprises:
at least two electromagnetic radiation sensor cells, the sensor cells comprising graphene as an electromagnetic radiation absorbing material; and
electrical connections between the at least two sensor cells, wherein the electrical connections are at least partially made of graphene.

2. The apparatus of claim 1, wherein the electrical connections are fully made of graphene.

3. The apparatus of any preceding claim, comprising a plurality of said sensor cells and a plurality of said electrical connections made of graphene.

4. An apparatus of any preceding claim, wherein the sensor cells form a row of sensor cells.

5. An apparatus of any preceding claim, wherein the sensor cells form an array of sensor cells.

6. An apparatus of any preceding claim, wherein the electrical connections between the sensor cells comprise graphene layers that extend into the sensor cells.

7. An apparatus of any preceding claim, wherein the sensor cells form a row of sensor cells and the electrical connections between the sensor cells comprise graphene layers that extend through sensor cells of the row of sensor cells.

8. An apparatus of any preceding claim, wherein the sensor cells form a row of sensor cells and the electrical connections between the sensor cells comprise graphene layers that extend over sensor cells of the row of sensor cells.

9. An apparatus of any preceding claim, wherein the sensor structure comprises graphene layers that extend through plurality of sensor cells of the structure.

10. The apparatus of claim 11, wherein graphene layers that extend through plurality of sensor cells of the structure form said electrical connections between the sensor cells.

11. An apparatus of any preceding claim, wherein the sensor cells comprise a plurality of stacked electromagnetic radiation sensing units, wherein each sensing unit comprises an electromagnetic radiation sensing layer made of graphene.

12. An apparatus of claim 11, wherein the sensor cells comprise 20-40 of said stacked electromagnetic radiation sensing units, and wherein the electromagnetic radiation sensing layer in each sensing unit comprises 10-30 layers of graphene.

13. An apparatus of any preceding claim, wherein the sensor cells are x-ray sensor cells.

14. An apparatus of any preceding claim, wherein the apparatus is an x-ray detector.

15. A method, comprising:
detecting electromagnetic radiation in sensor cells of a sensor structure comprising at least two sensor cells, the sensor cells comprising graphene as an electromagnetic radiation absorbing material; and
delivering electrical signals to and from the sensor cells through electrical connections that are at least partially made of graphene.
